# EUROPEAN PATENT SPECIFICATION

(11) **EP 1 349 010 B1**
(45) Date of publication and mention of the grant of the patent: **10.12.2014**
(21) Application number: 03251896.1
(22) Date of filing: 26.03.2003
(51) Int. Cl.: G03F 7/20, H05G 2/00

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 28.03.2002 EP 02252338
(43) Date of publication of application: 01.10.2003
(73) Proprietor: ASML Netherlands B.V., 5504 DR Veldhoven (NL)
(72) Inventor: Bakker, Levinus Pieter, 5708 ZT Helmond (NL); Jonkers, Jeroen, 52062 Aachen (DE); Van Dijsseldonk, Antonius Johannes Josephus, 5527 BH Hapert (NL); Dierichs, Marcel Mathijs Theodore Marie, 5914 WR Venlo (NL)
(74) Representative: Slenders, Petrus J. W.

(56) References cited:
- EP-A- 1 211 918
- WO-A-01/79936
- US-A- 4 408 338
- US-A- 4 866 517
- US-A1- 2002 090 054

## Description

The present invention relates to a lithographic projection apparatus comprising:
- a radiation system for supplying a pulsed projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth. Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e*.*g*. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

The performance of conventional lithographic projection apparatus, especially those employing EUV radiation, has been limited by losses in intensity of the radiation beams. These losses result in an overall loss in intensity of the beam, resulting in increased exposure times and therefore reduced throughput, and local losses in intensity which results in a loss of the uniformity of the image projected onto the substrate. This effect is especially severe for apparatus using EUV radiation since the EUV radiation is significantly absorbed by most materials. Therefore it is desirable for the path of the beam to be in a vacuum to prevent such losses.

WO01/79936 discloses an apparatus that prevents outgases contaminating the projection optics of an in vacuum lithography system. The apparatus comprises a rotating barrier having at least one aperture for the passage of light. The apparatus also comprises a spectral filter separating the source chamber from the optics chamber.

US 4 866 517 A discloses a laser plasma source of X-rays comprising a rotating aperture pressure barrier.

It is an object of the present invention to reduce the causes of beam intensity loss within a lithographic projection apparatus.

This and other objects are achieved according to the invention in a lithographic apparatus as specified in the opening paragraph, wherein said apparatus further comprises:
- a barrier for preventing gas flow from a first to a second part of said apparatus, said barrier comprising a controlled aperture arranged to permit passage of pulses of one of said projection beam of radiation and said patterned beam of radiation through the barrier when said controlled aperture is open and to substantially prevent gas flow from the first to the second part of the apparatus when the controlled aperture is closed; wherein said controlled aperture comprises: a first stationary member (3), integral with or connected to the barrier, provided with an opening (5) aligned with said beam of radiation;
   a rotating member (1), at least a part of which is adjacent to said first stationary member;
   a second stationary member (4), arranged such that at least a part of the rotating member (1) is located between the first (3) and second (4) stationary members; said second stationary member also being provided with an opening (6) aligned with said beam of radiation,
   wherein said rotating member has one or more openings (2) arranged such that, as said member rotates, an opening in the rotating member is periodically aligned with the openings in the stationary members, providing an opening through the barrier; and, when said openings are not aligned, the rotating member substantially prevents gas flow through the barrier, and
- a controller for operating the controlled aperture, for opening and closing the controlled aperture in synchronism with said pulsed beam.

This is advantageous if, for example, the gas present in the first part of the apparatus absorbs the radiation being used but the radiation is required to be transmitted through the second part of the apparatus. The gas flow between the first and second part of the apparatus is limited to only occur during the pulses of radiation thus significantly reducing the flow of gas. By reducing the gas flow to the second part of the apparatus less radiation will be absorbed. Such apparatus is also advantageous since any debris or other contaminants resulting from the pulse of radiation will typically arrive at the controlled aperture after it has closed (due to the debris being slower than the photons of the radiation beam). Therefore the controlled aperture will also provide an effective barrier against debris. This provides, periodically, an opening through the barrier which is closed at other times to prevent gas flow through the barrier. This configuration is advantageous as it is simple to implement, may be used at high cycle rates and may be adjusted for given situations by, for example, adjusting the speed of rotation of the rotating member and adjusting the sizes of the openings. The additional stationary member is advantageous since it reduces the leakage of gas around the rotating member when the aperture is closed.

The controlled aperture may further have a second rotating member, also located between the two stationary members. The second rotating member also has one or more openings arranged such that, as the second rotating member rotates, the openings are periodically aligned with the openings in the stationary members. For the opening through the controlled aperture to be open, thus enabling a beam of radiation to be radiated through the barrier, an opening in both the first and the second rotating member must be aligned with the openings in the stationary members. This configuration is advantageous since it can improve the control of the controlled aperture. For example, the first and second rotating members may be configured such that they can rotate in opposite directions. In this case, the opening through the controlled aperture is partially open for a shorter proportion of the operation cycle. This in turn reduces the amount of gas that flows between the first and second parts of the apparatus.

Furthermore, a space may be provided between the first and second rotating members. This space may, in a preferred configuration, be filled with a buffer gas. The buffer gas further reduces the amount of gas that flows from the first part of the apparatus to the second part of the apparatus. This may be especially advantageous if the gas flow from the first to the second part of the apparatus is detrimental to the performance of the second part of the apparatus. The buffer gas is chosen to be less detrimental to the performance of the second part of the apparatus than the gas flowing from the first part of the apparatus. The buffer gas may be refreshed, either constantly or periodically.

The space between the rotating members, and hence the amount of buffer gas required, may be reduced by providing a tube that extends from an edge surrounding an opening on the first rotating member to an edge surrounding an opening on the second rotating member. This may be necessary if, for example, the buffer gas that is required is costly or if the required refresh rate of gas in the space is high.

In a yet further alternative, the space between the two rotating members may be filled with a further stationary member with an opening aligned with the beam of radiation. This will reduce the flow of gas around the rotating members when the aperture is closed. It further reduces the flow of gas to the second part of the apparatus because the buffer gas only enters when it is required.

In an alternative to the invention as claimed, the controlled aperture may be comprised of a stationary member, that may be integral to or connected to the barrier, provided with an opening aligned with the beam of radiation. The controlled aperture further comprises a rotating member, located adjacent to the stationary member, provided with one or more openings that, as the rotating member rotates, are periodically aligned with the opening in the stationary member. This provides, periodically, an opening through the barrier which is closed at other times to prevent gas flow through the barrier. A tube is provided, extending from an edge surrounding the opening in the stationary member. The tube defines a space that opens into the second part of the apparatus. The space contains a buffer gas, provided from a buffer gas inlet when an opening in the rotating member is aligned with the inlet. This is advantageous since it is simple and therefore easily synchronized with the pulsed beam but it also reduces the impact of gas flows into the second part of the apparatus by means of the buffer gas.

In a preferred arrangement of the present invention, the radiation system comprises a radiation source which is provided on a first side of the barrier and a substantially evacuated system, provided on the other side of the barrier. This may be the case, for example, where the radiation source is an EUV discharge source requiring Xenon gas at a pressure of about 0.1 millibars and the EUV beam is required to be radiated through an evacuated system to reduce losses in beam intensity. The invention therefore is able to provide an opening through the barrier for the EUV beam to be transmitted to the evacuated system whilst minimizing the flow of Xenon gas into the evacuated system.

Alternatively or additionally, the present invention may be used to separate the substrate from the projection system. In this case, it is advantageous to use the controlled aperture of the present invention since the pulses of radiation on the substrate will result in outgassing from the resist on the substrate. It is undesirable for the gasses, and any contaminants (such as hydrocarbons) entrained therein, to flow into the projection system where the gas will cause a reduction in the intensity of the radiation beam and the contaminants may cause damage to the elements of the projection system. The controlled aperture of the present invention significantly reduces the flow of gasses to the projection system.

According to a further aspect of the invention there is provided a device manufacturing method comprising the steps of:
- providing a substrate (W) that is at least partially covered by a layer of radiation-sensitive material;
- providing a pulsed projection beam (PB) of radiation using a radiation system (LA, IL);
- using patterning means (MA) to endow the projection beam with a pattern in its cross-section;

- projecting the patterned beam of radiation onto a target portion of the layer of radiation-sensitive material,
- opening and closing, in synchronism with said pulsed beam, a controlled aperture in a barrier for preventing gas flow from a first to a second part of said apparatus;
- said controlled aperture providing an opening through the barrier aligned with one of said projection beam of radiation and said patterned patterned beam of radiation during pulses of said pulsed beam and substantially preventing gas flow from said first part to said second part of the apparatus between said pulses
- said controlled aperture comprising :
   a first stationary member (3), integral with or connected to the barrier, provided with an opening (5) aligned with said beam of radiation;
   a rotating member (1), at least a part of which is adjacent to said first stationary member;
   a second stationary member (4), arranged such that at least a part of the rotating member (1) is located between the first (3) and second (4) stationary members; said second stationary member also being provided with an opening (6) aligned with said beam of radiation,
   wherein said rotating member has one or more openings (2) arranged such that, as said member rotates, an opening in the rotating member is periodically aligned with the openings in the stationary member, providing an opening through the barrier; and, when said openings are not aligned, the rotating member substantially prevents gas flow through the barrier.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments (including embodiments of the invention) will now be described, by way of example only, with reference to the accompanying schematic drawings in which:
Figure 1 depicts a lithographic projection apparatus according to an embodiment of the invention;
Figure 2 depicts, in more detail, a portion of the apparatus shown in Figure 1.
Figures 3A and 3B depict a controlled aperture of the present invention using a single rotating plate;
Figures 4A and 4B depict a controlled aperture of the present invention utilizing two rotating plates;
Figures 5A through 5F depict a controlled aperture of the present invention at five instants through its cycle; and
Figures 6A and 6B depict a further controlled aperture. In the Figures, corresponding reference symbols indicate corresponding parts.

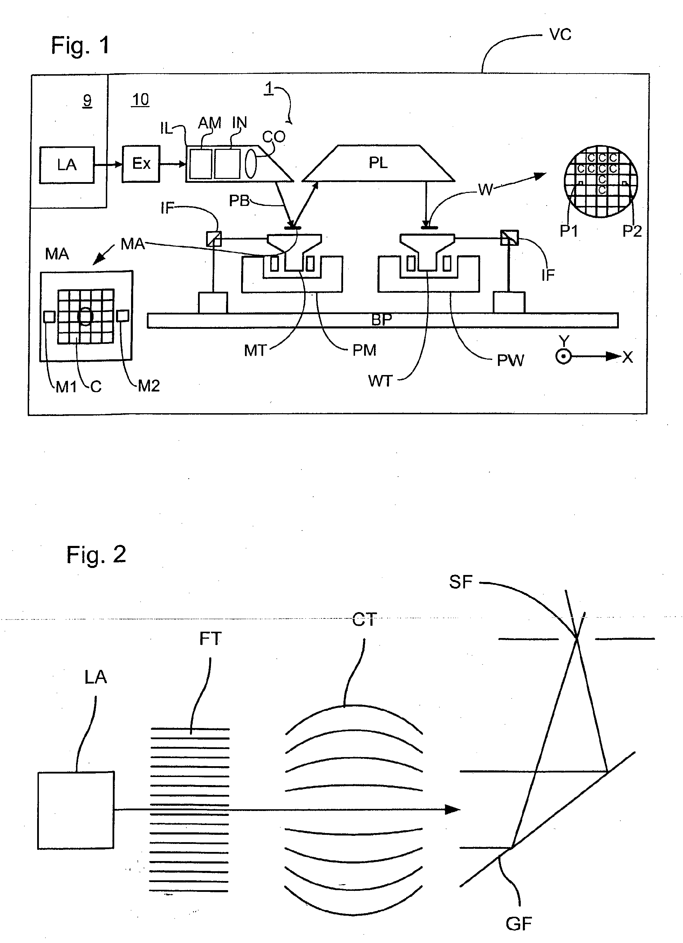

Figure 1 schematically depicts a lithographic projection apparatus according to a particular embodiment of the invention. The apparatus comprises:
· a radiation system Ex, IL, for supplying a projection beam PB of radiation (e.g. EUV radiation), which in this particular case also comprises a radiation source LA;
· a first object table (mask table) MT provided with a mask holder for holding a mask MA (*e*.*g*. a reticle), and connected to first positioning means PM for accurately positioning the mask with respect to item PL;
· a second object table (substrate table) WT provided with a substrate holder for holding a substrate W (*e*.*g*. a resist-coated silicon wafer), and connected to second positioning means PW for accurately positioning the substrate with respect to item PL;
· a projection system ("lens") PL (*e*.*g*. a mirror group) for imaging an irradiated portion of the mask MA onto a target portion C (*e*.*g*. comprising one or more dies) of the substrate W.

As here depicted, the apparatus is of a reflective type (*e*.*g*. has a reflective mask). However, in general, it may also be of a transmissive type, for example (*e*.*g*. with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

As shown in Figure 1, the apparatus is contained in a vacuum system VC. The source LA is located in a first evacuated compartment 9 and the remainder of the apparatus is located in a second evacuated compartment 10.

Figure 2 represents, in more detail, a portion of the apparatus shown in Figure 1. The source LA, which typically operates in an atmosphere of about 0.1 mbar of Xenon, produces a beam of radiation. The beam of radiation passes through a foil trap FT which collects debris from the source LA and restricts the flow of gas from the source side to its other side which will typically be at approximately 10⁻³ mbar. The beam of radiation subsequently traverses a collector CT and is reflected by a grating spectral filter GF into the main body of the apparatus which is a vacuum system which will typically operate at 10⁻⁶ mbar and contains, for example, the illumination system IL, patterning means MA, the projection system PLand the substrate W. The controlled aperture of the present invention is therefore required to permit pulsed beams of radiation to be transmitted between compartments of the apparatus which may operate at different pressures whilst minimizing the flow of gas between these compartments. Depending on the system requirements it can, for example, either replace or be in addition to the foil trap. In case of the latter, the controlled aperture may be located before or after the foil trap FT. A controlled aperture of the present invention may also be located after the grating spectral filter GF at a point of secondary focus SF.

Furthermore, the controlled aperture of the present invention may also be used between the projection system and the substrate. As the resist on the substrate is selectively developed by the radiation system, a significant amount of gas is produced. The controlled aperture may therefore be used as part of a barrier to prevent or minimize the flow of gas from the substrate to the projection system. This is especially important as there may be particles and/or other debris entrained in the gas flow.

Infrared radiation in the projection beam causes wafer-heating. Consequently, it is desirable to minimize the amount of infrared radiation in the projection beam. Most of this infrared radiation is generated by hot elements in the lithography apparatus and, in particular, in the source/collector module. The amount of infrared radiation produced by the hot elements is largely constant over time. Therefore the controlled aperture can be used to significantly reduce the infrared radiation since it will block it while the aperture is closed. A preferred position of of the controlled aperture for this use is at the intermediate focus, where the beam diameter is relatively small. It may, however, be used at other locations to reduce the infrared radiation reaching the wafer. To improve the performance of the controlled aperture in minimizing transmission of the infrared radiation to the wafer, an infrared reflective coating may be applied to the infrared source side of the controlled aperture (reducing the heat-load on the controlled aperture) and/or a coating with low emissivity may be applied to the other side (reducing the infrared radiation from the controlled aperture). Furthermore, the controlled aperture may also be temperature controlled and/or may be cooled.

Wherever the controlled aperture is located it must allow the beam of radiation through without any significant loss in beam intensity but it must restrict the flow of gas through the aperture since the pressure will need to be kept lower on one side and since the gas on one side may interfere with components on the other side.

In general, the aperture will be timed to be open for each pulse of the source LA. However, the opening of the aperture may be delayed for one or more pulses of the source such that, although the opening of the barrier is still synchronized to the beam, it does not let every pulse through. This may be used, for example, during start-up of the source since the energy level of the initial pulses may be unstable. The source may need to be started-up regularly during the exposure of a wafer.

For the sake of simplicity, the description, below, of specific controlled apertures of the present invention will be in the context of separating the source LA from the remainder of the apparatus. It will, however, be appreciated that they may be utilized in any situation such as those discussed above.

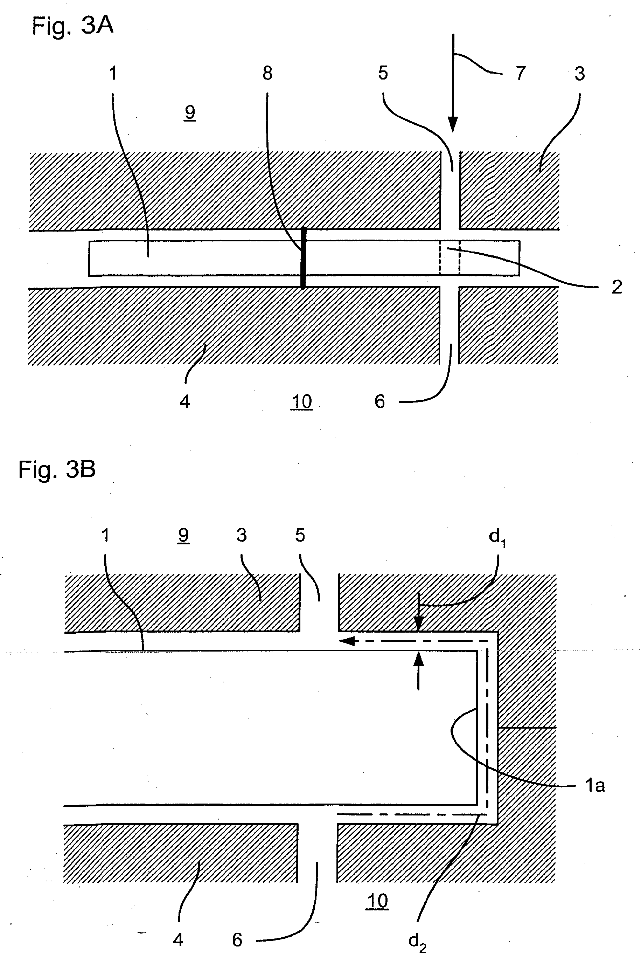

Fig. 3A depicts, in cross-section, a controlled aperture, taking the form of a "chopper", that may be used in the present invention. The chopper may be mounted onto or integrally formed in a barrier separating the first compartment 9 of the apparatus from the second compartment 10 of the apparatus. The chopper consists of a rotating plate 1 which rotates about an axis 8. The rotating plate is located between two stationary plates 3, 4. The stationary plates 3, 4 may be connected to or integral to the barrier separating the two compartments 9, 10. The stationary plates 3, 4 have apertures 5, 6 respectively, which are aligned with a beam of radiation 7. The rotating plate 1 has an opening 2. As the rotating plate 1 rotates, the opening 2 is periodically aligned with the openings 5, 6 in the stationary plates. When the opening 2 in the rotating member is aligned with the openings 5, 6 in the stationary plates 3, 4 an opening is provided through the barrier from the first compartment 9 to the second compartment 10. At other times, when the opening 2 in the rotating member 1 is not aligned with the openings 5, 6 in the stationary plates 3, 4, the rotating member 1 forms a barrier between the opening 5 in the first stationary plate 3 and the opening 6 in the second stationary plate 4. Therefore no opening is provided in the barrier between the first compartment 9 to the second compartment 10.

When the apparatus is used, the beam of radiation 7 used is provided as a series of pulses of radiation, and the rotation of the plate 1 is timed such that the openings 2, 5, 6 are aligned during pulses of radiation. The beam of radiation therefore may pass from the first compartment 9 to the second compartment 10. At other times the opening is closed, substantially preventing any flow of gas through the opening.

The rotating member 1 shown in Fig. 3A has a single opening 2. However, the rotating members may be provided with a plurality of openings. This reduces the speed at which the rotating member must rotate since it will no longer need to complete a complete revolution between pulses of radiation.

The effectiveness of the chopper shown in Fig. 3A for preventing the flow of gas between the first and second compartments 9, 10 is determined by how long the openings 2, 5, 6 are aligned or partially aligned and by how much gas flows around the rotating plate 1. Fig. 3B shows an enlarged view of part of the rotating plate 1 at an instant when the opening 2 in the rotating plate 1 is not aligned with the openings 5, 6 in the stationary plates 3, 4. The rate at which gas flows between the first and second compartments 9, 10 is dependent on the size d₁ of the gap between the rotating plate 1 and the stationary plates 3, 4 and the length d₂ that the gas must flow around the rotating plate 1. Unwanted gas flow around the chopper will be reduced if the gap d₁ between the rotating plate and the stationary plates is minimized and if the length of the flowpath d₂ around the rotating plate 1 is maximized. The latter may be effected by arranging the opening 2 in the rotating plate 1 as far as possible from the outside edge 1 a of the rotating plate. Alignment of the openings 2, 5, 6 provides an easy gas flowpath between the first and second compartments 9, 10 but since the opening 2, 5, 6 are not aligned for much of the duty cycle of the chopper, the gas flow is greatly reduced in comparison to a constantly open passage.

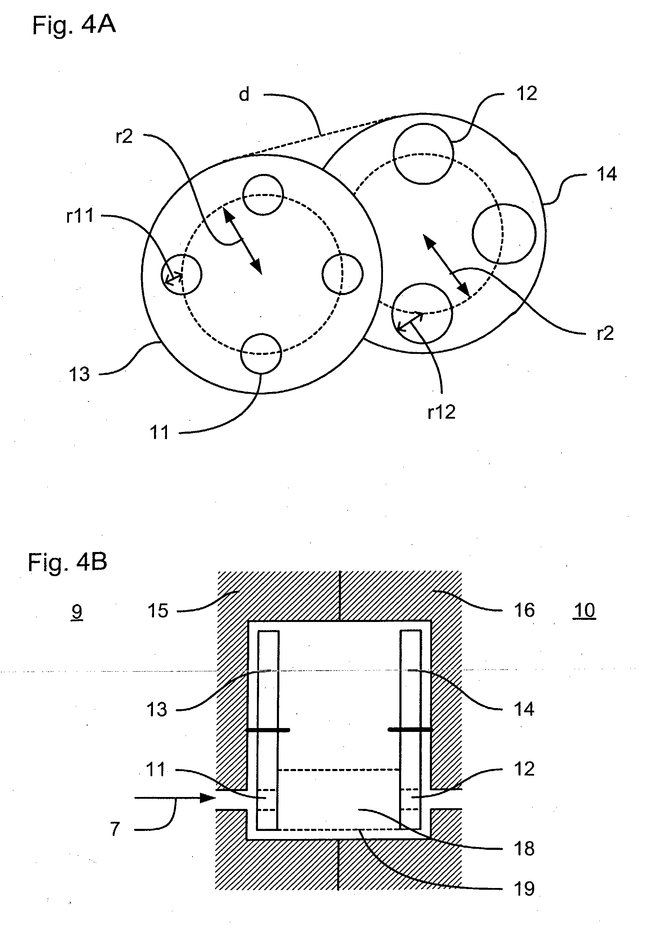

Fig. 4A shows part of an alternative configuration of a chopper of the present invention. In this case two rotating discs 13, 14 are disposed between two stationary plates (not shown). Again, for the chopper to be open (namely providing an opening through a barrier separating two compartments of the apparatus), the openings in the stationary plates (which are aligned with the beam of radiation) must be aligned with the openings 11, 12 on the first and second rotating discs 13, 14. Fig. 4B shows, in cross section, the rotating discs 13, 14 installed with the stationary plates 15, 16.

The openings 11, 12 in the rotating discs 13, 14 need not have the same radius r11, r12. However, the openings are preferably the same distance r2 from the center of rotation of the discs.

The rotating discs 13, 14 may be connected to each other to ensure that they rotate in unison, thus keeping the openings 11, 12 aligned. Alternatively the discs may be mounted such that they rotated at different speeds or, for example, in opposite directions. This requires greater precision as both discs must be correctly aligned with the openings in the stationary plates 15, 16 at the same time to allow the pulse of radiation through the opening in the barrier. However, rotating the plates in opposite directions advantageously reduces the amount of time that the chopper is partially open.

The rotating plates 13, 14 are arranged a distance d from each other, creating a space 18 between them. This space may, advantageously, be filled with a buffer gas which will further reduce the flow of gas from the first compartment to the second compartment through the chopper. This is important since the gas in the first compartment may have a detrimental effect on components of the apparatus in the second compartment. For example the Xenon in the source LA absorbs EUV radiation. It is therefore very important to minimize the amount of Xenon in the remainder of the apparatus. The buffer gas is selected for its relatively low impact on the remainder of the system. It is therefore less critical to prevent flow of the buffer gas into the second compartment than it is to prevent the gas in the first compartment from flowing into the second compartment. More information on such buffer gasses may be found in European Patent Application No. 01310947.5 corresponding to EP1329772 A. Argon, for example, may be used as the buffer gas.

In order to reduce the volume between the two discs that must be filled with buffer gas, a tube 19 (shown in dotted lines in Fig. 4B) may be inserted between the rotating discs 13, 14. The tube 19 may, if both discs rotate in unison, be attached to both rotating discs 13, 14. Alternatively, for example, if the rotating plates 13, 14 rotate in opposite directions, the tube 19 may be attached to only one of the rotating plates 13, 14 or may be attached to neither of the rotating plates 13, 14 but be in a fixed location with respect to the openings in the stationary plates 15, 16. Each end of the tube surrounds the opening 11, 12 in the rotating plate 13, 14 and may be attached to the edges of the openings. Where one of the openings is larger than the other, the tube 19 may be frustro-conical in shape.

The buffer gas may be replenished by a permanent flow through the space 18 between the rotating discs 13, 14. Alternatively the buffer gas may be replenished periodically. The buffer gas may be pumped out of the space 18, periodically or continuously, or may disperse.

As an alternative, the space 18 between the rotating plates 13, 14 may be filled with a third stationary plate with openings aligned with those of the first two stationary plates.

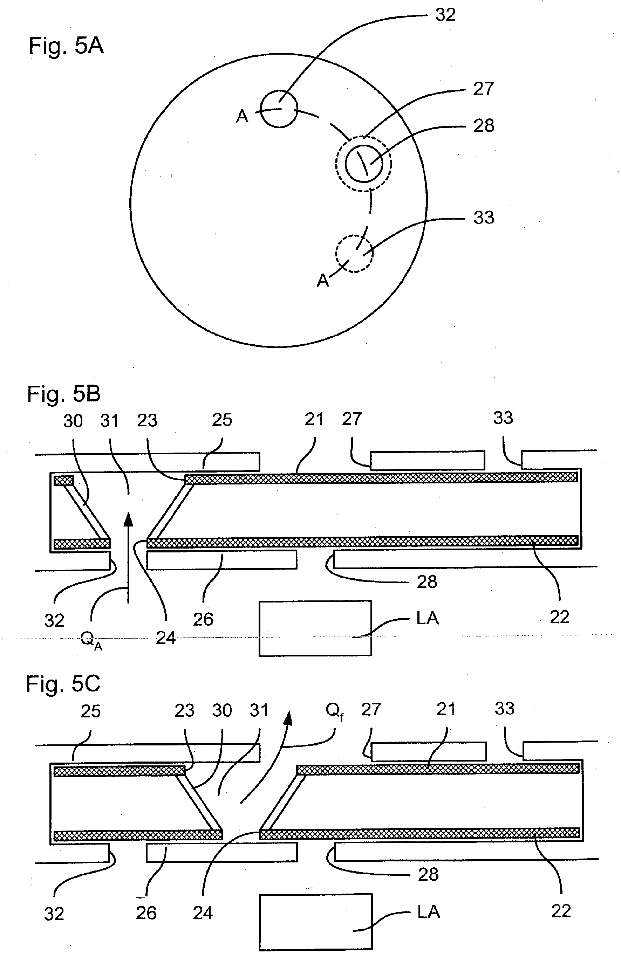

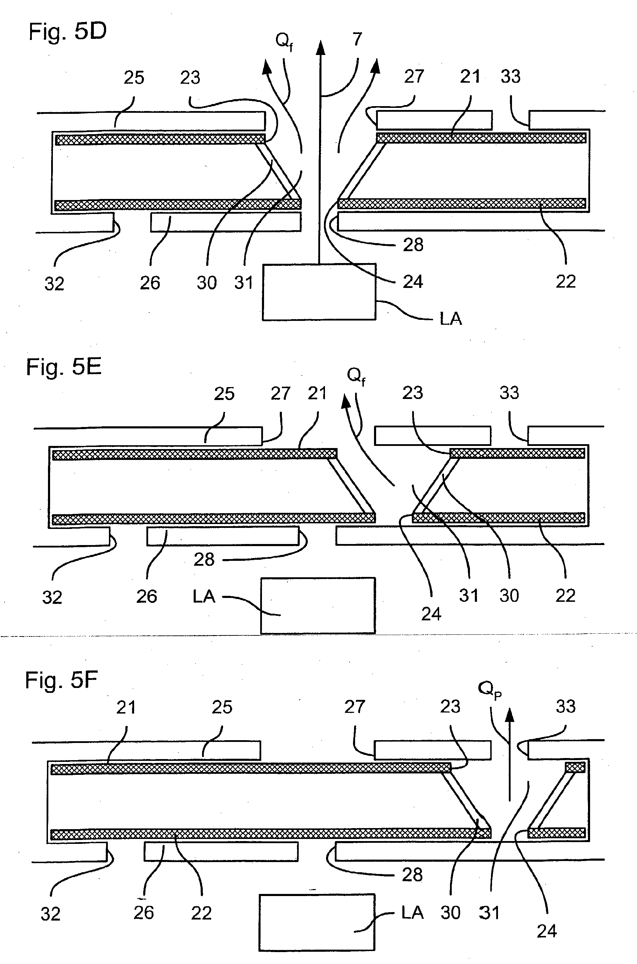

Figs. 5A to 5F show a chopper of the present invention which periodically replenishes the buffer gas in the space between two rotating discs. Figures 5B to 5F are cross-sections along the line A-A in Figure 5A. As in the example in Fig. 4A, the chopper is comprised of two rotating plates 21, 22, each of which has an opening 23, 24, respectively. The rotating plates 21, 22 are arranged between two stationary plates 25, 26. A frustro-conical surface 30 is provided between the openings 23, 24 in the rotating plates 21, 22. The surface 30 defines a space 31 that may be flushed with buffer gas.

At the instant shown in Fig. 5A the opening 24 in the first rotating plate 22 is aligned with a buffer inlet opening 32 in the first stationary plate 26. At this instant the pressure in the space 31 is lower than that in the buffer supply, resulting in a flow Q_{A} of buffer gas into the space 31. As the rotating discs 21, 22, with the surface 30 attached between them, rotate, the opening 24 in the first rotating plate moves out of alignment with the buffer inlet opening 32 in the first stationary plate 26.

At the instant shown in Fig. 5C the opening 24 in the first rotating disc 22 is no longer aligned at all with the buffer gas inlet opening 32 in the first stationary plate. The opening 23 in the second rotating plate 21 is, however, partially aligned with the radiation beam opening 27 in the second stationary plate. This results in some leakage of Q_{F} of the buffer gas from the space 31 into the second compartment of the apparatus.

At the instant shown in Fig. 5D the opening 24 in the first rotating plate 22 is aligned with the radiation beam opening 28 in the first stationary plate 26 and the opening 23 in the second rotating plate 21 is fully aligned with the radiation beam opening 27 in the second stationary plate. The chopper is therefore open, enabling a pulse of radiation 7 to be radiated from the source LA in the first compartment to the second compartment. Further leakage Q_{F} of the buffer gas into the second compartment occurs at this stage. However, provided that the opening is only open for a short duration, a significant amount of gas from the source chamber 9 will not leak through into the second compartment and the majority of the gas that does leak into the second compartment is merely the buffer gas.

At the instant shown in Fig. 5E the opening 24 in the first rotating plate 22 is no longer aligned with the radiation beam opening 28 in the first stationary plate. The opening 23 in the second rotating plate 21 is however partially aligned with the radiation beam opening 27 in the second stationary plate resulting in some further leakage Q_{F} of the buffer gas into the second compartment.

At the instant shown in Fig. 5G the opening 23 in the second rotating plate 21 is aligned with a buffer exhaust opening 33 in the second stationary plate. This is connected to a relatively large volume, maintained at a low pressure, and consequently the remaining buffer gas in space 31 is exhausted in a flow Qₚ through the opening.

For the chopper shown in Figures 5A to 5G to operate effectively, the characteristic time taken for the buffer gas to flow from the space 31 into the second compartment should be greater than the time for which the space 31 is (partially) open to the second compartment (namely the instants shown in Figures 5C, 5D and 5E). The time for which the space 31 is open to the second compartment can be reduced by moving the arrangement of the openings 32, 27, 28, 33 in the stationary plates 25, 26 (shown in Figure 5A) closer together. The characteristic time for the buffer gas to empty from the space 31 may be increased by adding a gas flow restriction that is transparent to the radiation, such as a foil trap, on the side of the chopper to which the buffer gas flows.

As shown in Figures 5B to 5G the frustro-conical surface 30 is attached to the rotating plates 21, 22. However, this need not be the case and the surface may be fixed relative to the stationary plates, the opening in the rotating plates aligning with it when they are aligned with the openings in the stationary plates. In such a case the surface may need to be larger. Additionally the surface need not be frustro-conical in shape.

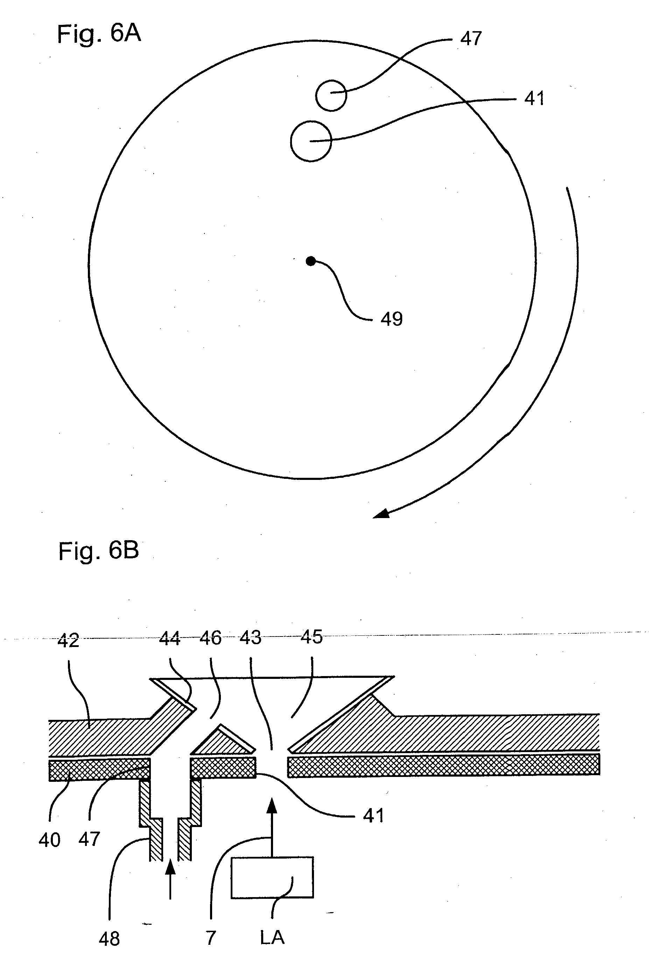

Figs. 6A and 6B show, a further variant of a chopper. A rotating plate 40 is provided adjacent to a stationary plate 42. As the rotating plate 40 rotates, an opening 41 in it is periodically aligned with an opening 43 in the stationary plate, allowing a beam of radiation 7, from the source LA, to be radiated through the barrier. The stationary plate 42 is provided with a surface 44 that defines an interface space 45. The interface space may be provided with a buffer gas to reduce leakage of gas from the first compartment through the barrier. The surface 44 has an opening 46, that periodically becomes aligned with a second opening 47 in the rotating plate 40. This may be used to provide fresh buffer gas to the interface space 45. As the rotating plate rotates the opening 47 in the rotating plate 40 aligns with a buffer gas supply opening 48, enabling buffer gas to flow through to the interface space 45.

As shown in Figure 6A the radiation beam opening 41 and the buffer gas opening 47 are arranged on the rotating plate at different distances from its axis of rotation 49. This enables the buffer gas to be provided to the interface space 45 at substantially the same time as the radiation beam is passing through the chopper. Alternatively, as shown in figure 6A, the buffer gas opening 47 may be arranged to supply buffer gas to the interface space 45 slightly before the radiation beam opening 41 on the rotating plate 40 aligns with the opening 43 on the stationary plate.

Whilst specific embodiments of the invention have been described above, it will be appreciated that the invention may be practiced otherwise than as described. The description is not intended to limit the invention.

## Claims

1. A lithographic projection apparatus comprising:
- a radiation system (LA, IL) for providing a pulsed projection beam of radiation;
- a support structure (MT) for supporting patterning means (MA), the patterning means serving to pattern the projection beam according to a desired pattern;
- a substrate table (WT) for holding a substrate (W);
- a projection system (PL) for projecting the patterned beam onto a target portion of the substrate, wherein said apparatus further comprises:
- a barrier for preventing gas flow from a first to a second part of said apparatus, said barrier comprising a controlled aperture arranged to permit passage of pulses of one of said projection beam of radiation and said patterned beam of radiation through the barrier when said controlled aperture is open and to substantially prevent gas flow from the first to the second part of the apparatus when the controlled aperture is closed; wherein said controlled aperture comprises:
a first stationary member (3), integral with or connected to the barrier,
provided with an opening (5) aligned with said beam of radiation;
a rotating member (1), at least a part of which is adjacent to said first stationary member;
a second stationary member (4), arranged such that at least a part of the rotating member (1) is located between the first (3) and second (4) stationary members; said second stationary member also being provided with an opening (6) aligned with said beam of radiation,
wherein said rotating member has one or more openings (2) arranged such that, as said member rotates, an opening in the rotating member is periodically aligned with the openings in the stationary members, providing an opening through the barrier; and, when said openings are not aligned, the rotating member substantially prevents gas flow through the barrier, and
- a controller for operating the controlled aperture, for opening and closing the controlled aperture in synchronism with said pulsed beam.

2. A lithographic projection apparatus according to claim 1, further comprising a second rotating member (14) at least a part of which is located between the first and second stationary members (15, 16);
wherein said second rotating member (14) has one or more openings (12) arranged such that, as said second rotating member rotates, an opening in the second rotating member is periodically aligned with the openings in the stationary members (15, 16), providing an opening through the barrier if, simultaneously, an opening (11) in the first rotating member (13) is aligned with the openings in the stationary members; and when no opening in the second rotating member is aligned with the openings in the stationary member, the second rotating member substantially prevents gas flow through the barrier.

3. A lithographic projection apparatus according to claim 2, further comprising a space (18), containing a buffer gas, between said first and second rotating members (13, 14).

4. A lithographic projection apparatus according to claim 3, further comprising:
a buffer gas inlet (32) for supplying buffer gas to said space (31) between the first and second rotating members (21, 22) when an opening (24) in one of said rotating members (22) is aligned with said inlet; and
a buffer gas exhaust (33) for exhausting the buffer gas from said space (31) when an opening (23) in one of said rotating members (21) is aligned with said exhaust.

5. A lithographic projection apparatus according to claim 3 or 4, further comprising a tube (30) that, at least when the controlled aperture is open, extends from an edge surrounding an opening (23) on said first rotating member (21) to an edge surrounding an opening (24) on said second rotating member (22); and wherein said tube limits said space (31).

6. A lithographic projection apparatus according to claim 5, wherein said opening (23) surrounded by said tube (30) on said first rotating member (21) is larger than said opening (24) surrounded by said tube on said second rotating member (22) and said tube is frustro-conical in shape.

7. A lithographic projection apparatus according to claim 5 or 6, wherein said tube (30) is fixed in a position aligned with the openings (27, 28) on the stationary members (25, 26).

8. A lithographic projection apparatus according to claim 5 or 6, wherein said first and second rotating members (21, 22) rotate in unison and said tube (30) is attached to said rotating members.

9. A lithographic projection apparatus according to claim 2, further comprising a third stationary plate, at least a part of which is located between the first and second rotating members; said third stationary member also provided with an opening aligned with said beam of radiation.

10. A lithographic projection apparatus according to any one of claims 2 to 7, wherein said first and second rotating members (13, 14) rotate in opposite directions.

11. A lithographic projection apparatus according to any preceding claim,
wherein said radiation system comprises a radiation source (LA) which is in said first part (9) of the apparatus; and the second part (10) of the apparatus is a substantially evacuated system.

12. A lithographic projection apparatus according to any one of claims 1 to 10, wherein said substrate table (WT) is in said first part (9) of the apparatus and said second part of the apparatus is the projection system (PL).

13. A device manufacturing method comprising the steps of:
- providing a substrate (W) that is at least partially covered by a layer of radiationsensitive material;
- providing a pulsed projection beam (PB) of radiation using a radiation system (LA, IL);
- using patterning means (MA) to endow the projection beam with a pattern in its cross-section;
- projecting the patterned beam of radiation onto a target portion of the layer of radiation-sensitive material, opening and closing, in synchronism with said pulsed beam, a controlled aperture in a barrier for preventing gas flow from a first to a second part of said apparatus;
- said controlled aperture providing an opening through the barrier aligned with one of said projection beam of radiation and said patterned beam of radiation during pulses of said pulsed beam and substantially preventing gas flow from said first part to said second part of the apparatus between said pulses
- said controlled aperture comprising :
a first stationary member (3), integral with or connected to the barrier, provided with an opening (5) aligned with said beam of radiation;
a rotating member (1), at least a part of which is adjacent to said first stationary member;
a second stationary member (4), arranged such that at least a part of the rotating member (1) is located between the first (3) and second (4) stationary members; said second stationary member also being provided with an opening (6) aligned with said beam of radiation,
wherein said rotating member has one or more openings (2) arranged such that, as said member rotates, an opening in the rotating member is periodically aligned with the openings in the stationary member, providing an opening through the barrier; and, when said openings are not aligned, the rotating member substantially prevents gas flow through the barrier.

## Patentansprüche

1. Ein lithographisches Projektionsgerät, das Folgendes beinhaltet:
- ein Strahlungssystem (LA, IL) zum Bereitstellen eines gepulsten Projektionsstrahls aus Strahlung;
- eine Stützstruktur (MT) zum Stützen eines Musteraufbringungsmittels (MA), wobei das Musteraufbringungsmittel dazu dient, den Projektionsstrahl gemäß einem gewünschten Muster zu mustern;
- einen Substrattisch (WT) zum Halten eines Substrats (W);
- ein Projektionssystem (PL) zum Projizieren des gemusterten Strahls auf einen Zielabschnitt des Substrats, wobei das Gerät ferner Folgendes beinhaltet:
- eine Barriere zum Verhindern eines Gasflusses von einem ersten zu einem zweiten Teil des Geräts, wobei die Barriere einen gesteuerten Durchlass beinhaltet, der eingerichtet ist, um den Durchgang von Impulsen von einem von dem Projektionsstrahl aus Strahlung und dem gemusterten Strahl aus Strahlung durch die Barriere zu erlauben, wenn der gesteuerte Durchlass offen ist, und um einen Gasfluss von dem ersten zu dem zweiten Teil des Geräts im Wesentlichen zu verhindern, wenn der gesteuerte Durchlass geschlossen ist; wobei der gesteuerte Durchlass Folgendes beinhaltet:
ein erstes stationäres Element (3), das mit der Barriere integral ist oder mit ihr verbunden ist,
versehen mit einer Öffnung (5) in Linie mit dem Strahl aus Strahlung;
ein Drehelement (1), von dem sich mindestens ein Teil neben dem ersten stationären Element befindet;
ein zweites stationäres Element (4), das so eingerichtet ist, dass sich mindestens ein Teil des Drehelements (1) zwischen dem ersten (3) und dem zweiten (4) stationären Element befindet; wobei das zweite stationäre Element ebenfalls mit einer Öffnung (6) in Linie mit dem Strahl aus Strahlung versehen ist,
wobei das Drehelement eine oder mehrere Öffnungen (2) aufweist, die so eingerichtet sind, dass während sich das Element dreht, eine Öffnung in dem Drehelement periodisch mit den Öffnungen in den stationären Elementen in Linie gebracht wird, was eine Öffnung durch die Barriere bereitstellt; und, wenn die Öffnungen nicht in Linie sind, das Drehelement einen Gasfluss durch die Barriere im Wesentlichen verhindert, und
- eine Steuereinheit zum Betreiben des gesteuerten Durchlasses, um den gesteuerten Durchlass in Synchronisation mit dem gepulsten Strahl zu öffnen und zu schließen.

2. Lithographisches Projektionsgerät gemäß Anspruch 1, das ferner ein zweites Drehelement (14) beinhaltet, von dem sich mindestens ein Teil zwischen dem ersten und dem zweiten stationären Element (15, 16) befindet;
wobei das zweite Drehelement (14) eine oder mehrere Öffnungen (12) aufweist, die so eingerichtet sind, dass, wenn sich das zweite Drehelement dreht, eine Öffnung in dem zweiten Drehelement periodisch mit den Öffnungen in den stationären Elementen (15, 16) in Linie gebracht wird, was eine Öffnung durch die Barriere bereitstellt, wenn gleichzeitig eine Öffnung (11) in dem ersten Drehelement (13) mit den Öffnungen in den stationären Elementen in Linie ist; und wenn keine Öffnung in dem zweiten Drehelement mit den Öffnungen in dem stationären Element in Linie ist, das zweite Drehelement einen Gasfluss durch die Barriere im Wesentlichen verhindert.

3. Lithographisches Projektionsgerät gemäß Anspruch 2, das ferner einen Raum (18), der ein Puffergas enthält, zwischen dem ersten und dem zweiten Drehelement (13, 14) beinhaltet.

4. Lithographisches Projektionsgerät gemäß Anspruch 3, das ferner Folgendes beinhaltet:
einen Puffergaseinlass (32) zum Zuführen von Puffergas zu dem Raum (31) zwischen dem ersten und dem zweiten Drehelement (21, 22), wenn eine Öffnung (24) in einem der Drehelemente (22) mit dem Einlass in Linie ist; und
einen Puffergasauslass (33) zum Auslassen des Puffergases aus dem Raum (31), wenn eine Öffnung (23) in einem der Drehelemente (21) mit dem Auslass in Linie ist.

5. Lithographisches Projektionsgerät gemäß Anspruch 3 oder 4, das ferner eine Röhre (30) beinhaltet, die sich, zumindest wenn der gesteuerte Durchlass offen ist, von einer eine Öffnung (23) auf dem ersten Drehelement (21) umgebenden Kante zu einer eine Öffnung (24) auf dem zweiten Drehelement (22) umgebenden Kante erstreckt; und wobei die Röhre den Raum (31) begrenzt.

6. Lithographisches Projektionsgerät gemäß Anspruch 5, wobei die von der Röhre (30) umgebende Öffnung (23) auf dem ersten Drehelement (21) größer als die von der Röhre umgebende Öffnung (24) auf dem zweiten Drehelement (22) ist und die Röhre eine kegelstumpfförmige Form aufweist.

7. Lithographisches Projektionsgerät gemäß Anspruch 5 oder 6, wobei die Röhre (30) in einer Position fixiert ist, die mit den Öffnungen (27, 28) auf den stationären Elementen (25, 26) in Linie ist.

8. Lithographisches Projektionsgerät gemäß Anspruch 5 oder 6, wobei sich das erste und das zweite Drehelement (21, 22) gemeinsam drehen und die Röhre (30) an den Drehelementen befestigt ist.

9. Lithographisches Projektionsgerät gemäß Anspruch 2, das ferner eine dritte stationäre Platte beinhaltet, von der sich mindestens ein Teil zwischen dem ersten und dem zweiten Drehelement befindet; wobei das dritte stationäre Element auch mit einer Öffnung versehen ist, die mit dem Strahl aus Strahlung in Linie ist.

10. Lithographisches Projektionsgerät gemäß einem der Ansprüche 2 bis 7, wobei sich das erste und das zweite Drehelement (13, 14) in entgegengesetzten Richtungen drehen.

11. Lithographisches Projektionsgerät gemäß einem der vorhergehenden Ansprüche, wobei das Strahlungssystem eine Strahlungsquelle (LA) beinhaltet, die sich in dem ersten Teil (9) des Geräts befindet; und der zweite Teil (10) des Geräts ein im Wesentlichen evakuiertes System ist.

12. Lithographisches Projektionsgerät gemäß einem der Ansprüche 1 bis 10, wobei sich der Substrattisch (WT) in dem ersten Teil (9) des Geräts befindet und der zweite Teil des Geräts das Projektionssystem (PL) ist.

13. Ein Verfahren zum Herstellen einer Vorrichtung, das die folgenden Schritte beinhaltet:
- Bereitstellen eines Substrats (W), das mindestens teilweise mit einer Schicht aus strahlungsempfindlichem Material überzogen ist;
- Bereitstellen eines gepulsten Projektionsstrahls (PB) aus Strahlung unter Verwendung eines Strahlungssystems (LA, IL);
- Verwenden eines Musteraufbringungsmittels (MA), um den Projektionsstrahl in seinem Querschnitt mit einem Muster zu versehen;
- Projizieren des gemusterten Strahls aus Strahlung auf einen Zielabschnitt der Schicht aus strahlungsempfindlichem Material,
- Öffnen und Schließen eines gesteuerten Durchlasses in einer Barriere zum Verhindern eines Gasflusses von einem ersten zu einem zweiten Teil des Geräts in Synchronisation mit dem gepulsten Strahl;
- wobei der gesteuerte Durchlass während Impulsen des gepulsten Strahls eine Öffnung durch die Barriere bereitstellt, die mit einem von dem Projektionsstrahl aus Strahlung und dem gemusterten Strahl aus Strahlung in Linie ist, und zwischen den Impulsen einen Gasfluss von dem ersten Teil zu dem zweiten Teil des Geräts im Wesentlichen verhindert;
- wobei der gesteuerte Durchlass Folgendes beinhaltet:
ein erstes stationäres Element (3), das mit der Barriere integral ist oder mit ihr verbunden ist, versehen mit einer Öffnung (5), die mit dem Strahl aus Strahlung in Linie ist;
ein Drehelement (1), von dem sich mindestens ein Teil neben dem ersten stationären Element befindet;
ein zweites stationäres Element (4), das so eingerichtet ist, dass sich mindestens ein Teil des Drehelements (1) zwischen dem ersten (3) und dem zweiten (4) stationären Element befindet; wobei das zweite stationäre Element ebenfalls mit einer Öffnung (6) versehen ist, die mit dem Strahl aus Strahlung in Linie ist,
wobei das Drehelement eine oder mehrere Öffnungen (2) aufweist, die so eingerichtet sind, dass während sich das Element dreht, eine Öffnung in dem Drehelement periodisch mit den Öffnungen in dem stationären Element in Linie gebracht wird, was eine Öffnung durch die Barriere bereitstellt; und, wenn die Öffnungen nicht in Linie sind, das Drehelement einen Gasfluss durch die Barriere im Wesentlichen verhindert.

## Revendications

1. Un appareil de projection lithographique comprenant :
- un système de rayonnement (LA, IL) destiné à fournir un faisceau de projection pulsé de rayonnement ;
- une structure formant support (MT) destinée à supporter un moyen pour conformer selon un motif (MA), le moyen pour conformer selon un motif servant à conformer le faisceau de projection selon un motif souhaité ;
- une table porte-substrat (WT) destinée à porter un substrat (W) ;
- un système de projection (PL) destiné à projeter le faisceau à motif sur une portion cible du substrat, ledit appareil comprenant en sus :
- une barrière destinée à empêcher un écoulement de gaz d'une première à une deuxième partie dudit appareil, ladite barrière comprenant une ouverture contrôlée arrangée afin de permettre le passage d'impulsions soit dudit faisceau de projection de rayonnement, soit dudit faisceau de rayonnement à motif à travers la barrière lorsque ladite ouverture contrôlée est ouverte et afin d'empêcher substantiellement un écoulement de gaz de la première à la deuxième partie de l'appareil lorsque l'ouverture contrôlée est fermée ; où ladite ouverture contrôlée comprend :
un premier élément stationnaire (3), solidaire de la barrière ou raccordé à celle-ci,
pourvu d'un orifice (5) aligné avec ledit faisceau de rayonnement ;
un élément rotatif (1) dont une partie au moins est adjacente audit premier élément stationnaire ;
un deuxième élément stationnaire (4), arrangé de telle sorte qu'au moins une partie de l'élément rotatif (1) soit située entre les premier (3) et deuxième (4) éléments stationnaires ; ledit deuxième élément stationnaire étant également pourvu d'un orifice (6) aligné avec ledit faisceau de rayonnement,
où ledit élément rotatif a un ou plusieurs orifices (2) arrangés de telle sorte que, à mesure que ledit élément tourne, un orifice dans l'élément rotatif soit périodiquement aligné avec les orifices dans les éléments stationnaires, fournissant un orifice à travers la barrière ; et, lorsque lesdits orifices ne sont pas alignés, l'élément rotatif empêche substantiellement un écoulement de gaz à travers la barrière, et
- un organe de contrôle destiné à faire fonctionner l'ouverture contrôlée, pour ouvrir et fermer l'ouverture contrôlée en synchronisme avec ledit faisceau pulsé.

2. Un appareil de projection lithographique selon la revendication 1, comprenant en sus un deuxième élément rotatif (14) dont une partie au moins est située entre les premier et deuxième éléments stationnaires (15, 16) ;
où ledit deuxième élément rotatif (14) a un ou plusieurs orifices (12) arrangés de telle sorte que, à mesure que ledit deuxième élément rotatif tourne, un orifice dans le deuxième élément rotatif soit périodiquement aligné avec les orifices dans les éléments stationnaires (15, 16), fournissant un orifice à travers la barrière si, simultanément, un orifice (11) dans le premier élément rotatif (13) est aligné avec les orifices dans les éléments stationnaires ; et lorsqu'aucun orifice dans le deuxième élément rotatif n'est aligné avec les orifices dans l'élément stationnaire, le deuxième élément rotatif empêche substantiellement un écoulement de gaz à travers la barrière.

3. Un appareil de projection lithographique selon la revendication 2, comprenant en sus un espace (18), contenant un gaz tampon, entre lesdits premier et deuxième éléments rotatifs (13, 14).

4. Un appareil de projection lithographique selon la revendication 3, comprenant en sus :
une entrée de gaz tampon (32) destinée à amener du gaz tampon dans ledit espace (31) entre les premier et deuxième éléments rotatifs (21, 22) lorsqu'un orifice (24) dans l'un desdits éléments rotatifs (22) est aligné avec ladite entrée ; et
une sortie de gaz tampon (33) destinée à laisser s'échapper le gaz tampon dudit espace (31) lorsqu'un orifice (23) dans l'un desdits éléments rotatifs (21) est aligné avec ladite sortie.

5. Un appareil de projection lithographique selon la revendication 3 ou la revendication 4, comprenant en sus un tube (30) qui, au moins lorsque l'ouverture contrôlée est ouverte, s'étend d'un bord entourant un orifice (23) sur ledit premier élément rotatif (21) à un bord entourant un orifice (24) sur ledit deuxième élément rotatif (22) ; et où ledit tube limite ledit espace (31).

6. Un appareil de projection lithographique selon la revendication 5, où ledit orifice (23) entouré par ledit tube (30) sur ledit premier élément rotatif (21) est plus grand que ledit orifice (24) entouré par ledit tube sur ledit deuxième élément rotatif (22) et ledit tube est de forme tronconique.

7. Un appareil de projection lithographique selon la revendication 5 ou la revendication 6, où ledit tube (30) est fixé dans une position alignée avec les orifices (27, 28) sur les éléments stationnaires (25, 26).

8. Un appareil de projection lithographique selon la revendication 5 ou la revendication 6, où lesdits premier et deuxième éléments rotatifs (21, 22) tournent à l'unisson et ledit tube (30) est attaché auxdits éléments rotatifs.

9. Un appareil de projection lithographique selon la revendication 2, comprenant en sus une troisième plaque stationnaire dont une partie au moins est située entre les premier et deuxième éléments rotatifs ; ledit troisième élément stationnaire étant également pourvu d'un orifice aligné avec ledit faisceau de rayonnement.

10. Un appareil de projection lithographique selon l'une quelconque des revendications 2 à 7, où lesdits premier et deuxième éléments rotatifs (13, 14) tournent dans des directions opposées.

11. Un appareil de projection lithographique selon n'importe quelle revendication précédente, où ledit système de rayonnement comprend une source de rayonnement (LA) qui se trouve dans ladite première partie (9) de l'appareil ; et la deuxième partie (10) de l'appareil est un système substantiellement sous vide.

12. Un appareil de projection lithographique selon l'une quelconque des revendications 1 à 10, où ladite table porte-substrat (WT) se trouve dans ladite première partie (9) de l'appareil et ladite deuxième partie de l'appareil est le système de projection (PL).

13. Un procédé de fabrication de dispositif comprenant les étapes consistant :
- à fournir un substrat (W) qui est au moins en partie recouvert d'une couche de matériau sensible au rayonnement ;
- à fournir un faisceau de projection pulsé (PB) de rayonnement à l'aide d'un système de rayonnement (LA, IL) ;
- à utiliser un moyen pour conformer selon un motif (MA) afin de doter le faisceau de projection d'un motif dans sa coupe transversale ;
- à projeter le faisceau de rayonnement à motif sur une portion cible de la couche de matériau sensible au rayonnement,
- à ouvrir et à fermer, en synchronisme avec ledit faisceau pulsé, une ouverture contrôlée dans une barrière destinée à empêcher un écoulement de gaz d'une première à une deuxième partie dudit appareil ;
- ladite ouverture contrôlée fournissant un orifice à travers la barrière aligné soit avec ledit faisceau de projection de rayonnement, soit avec ledit faisceau de rayonnement à motif pendant des impulsions dudit faisceau pulsé et empêchant substantiellement un écoulement de gaz de ladite première partie à ladite deuxième partie de l'appareil entre lesdites impulsions
- ladite ouverture contrôlée comprenant :
un premier élément stationnaire (3), solidaire de la barrière ou raccordé à celle-ci,
pourvu d'un orifice (5) aligné avec ledit faisceau de rayonnement ;
un élément rotatif (1) dont une partie au moins est adjacente audit premier élément stationnaire ;
un deuxième élément stationnaire (4), arrangé de telle sorte qu'au moins une partie de l'élément rotatif (1) soit située entre les premier (3) et deuxième (4) éléments stationnaires ; ledit deuxième élément stationnaire étant également pourvu d'un orifice (6) aligné avec ledit faisceau de rayonnement,
où ledit élément rotatif a un ou plusieurs orifices (2) arrangés de telle sorte que, à mesure que ledit élément tourne, un orifice dans l'élément rotatif soit périodiquement aligné avec les orifices dans l'élément stationnaire, fournissant un orifice à travers la barrière ; et, lorsque lesdits orifices ne sont pas alignés, l'élément rotatif empêche substantiellement un écoulement de gaz à travers la barrière.
